Europäisches Patentamt

European Patent Office

Office européen des brevets

(19)

(11) **EP 0 640 259 B1**

(12) **EUROPÄISCHE PATENTSCHRIFT**

(45) Veröffentlichungstag und Bekanntmachung des
Hinweises auf die Patenterteilung:
**01.05.1996  Patentblatt 1996/18**

(21) Anmeldenummer: **93912701.5**

(22) Anmeldetag: **10.05.1993**

(51) Int Cl.⁶: **H03K 3/023**

(86) Internationale Anmeldenummer:
**PCT/EP93/01139**

(87) Internationale Veröffentlichungsnummer:
**WO 93/23925 (25.11.1993 Gazette 1993/28)**

(54) **SCHMITT-TRIGGER**

SCHMITT-TRIGGER

BASCULE DE SCHMITT

(84) Benannte Vertragsstaaten:
**DE FR GB IT**

(30) Priorität: **11.05.1992  DE 4215423**

(43) Veröffentlichungstag der Anmeldung:
**01.03.1995  Patentblatt 1995/09**

(73) Patentinhaber: **SGS-THOMSON
MICROELECTRONICS GMBH
D-85630 Grasbrunn (DE)**

(72) Erfinder: **ERCKERT, Ricardo
D-8019 A ling (DE)**

(74) Vertreter: **Klunker . Schmitt-Nilson . Hirsch
Winzererstrasse 106
D-80797 München (DE)**

(56) Entgegenhaltungen:
**EP-A- 0 107 189          WO-A-89/00789**

- **PATENT ABSTRACTS OF JAPAN, Bd. 11, Nr. 320
  (E-550)17. Oktober 1987;& JP-A-62110314**
- **PATENT ABSTRACTS OF JAPAN, Bd. 9, Nr. 35
  (E-296)(1758) 14. Februar 1985;& JP-A-59176926**
- **PATENT ABSTRACTS OF JAPAN, Bd. 10, Nr. 117
  (E-400)2. Mai 1986;& JP-A-60250711**

**Beschreibung**

Die Erfindung betrifft einen Schmitt-Trigger mit einer Komparatorschaltung, die einem über einen Signaleingang zugeführten Eingangssignal schwellenabhängig einen niedrigen oder einen hohen Ausgangssignalwert zuordnet; mit zwei bezüglich des Signaleingangs parallel geschalteten Komparatoren, wobei einem ersten der beiden Komparatoren ein oberer Schwellenwert und dem zweiten der beiden Komparatoren ein darunter liegender unterer Schwellenwert zugeordnet ist; mit zwei Stromquellen, von denen eine erste den ersten Komparator und eine zweite den zweiten Komparator mit Strom versorgt; mit einer Speicherschaltung, deren Speicherwert von der Lage des Eingangssignals bezüglich der beiden Schwellenwerte abhängt; und mit einer Abschalteinrichtung, die dann, wenn das Eingangssignal den ersten Schwellenwert überschreitet, den ersten Komparator stromlos schaltet, und die dann, wenn das Eingangssignal den zweiten Schwellenwert unterschreitet, den zweiten Komparator stromlos schaltet.

Schmitt-Trigger werden verwendet, um festzustellen, ob ein Signal unter oder über einem bestimmten Schwellenwert liegt. Auf diese Weise kann beispielsweise Logiksignalen, auch wenn sie aufgrund von Beeinträchtigungen während der Signalverarbeitung oder Signalübertragung eine Abweichung von dem ihrem Logikwert eigentlich entsprechenden Spannungswert aufweisen, im allgemeinen noch sicher der korrekte Logikwert zugeordnet werden.

Ein Beispiel eines Schmitt-Triggers der eingangs angegebenen Art, der trotz Speicherschaltung und Abschalteinrichtung laufend Strom verbraucht und somit die Energieversorgungsquelle laufend belastet, ist bekannt aus PATENTS ABSTRACTS OF JAPAN, Vol. 11, No. 320 (E-550) 17. Oktober 1987, betreffend die JP-A-62 110 314. Bei diesem bekannten Schmitt-Trigger ist erreicht worden, daß die Quelle eines dem Schmitt-Trigger zugeführten Eingangssignals in keinem der Betriebszustände des Schmitt-Triggers mit Strom belastet wird, mit Ausnahme kurzer Momente bei einer ausgangsseitigen Zustandsänderung dieses Schmitt-Triggers. Dies wird dadurch erreicht, daß in jedem Betriebszustand des Schmitt-Triggers von den beiden Transistoren der beiden Komparatoren, deren Steuerelektroden mit dem Signaleingang verbunden sind, derjenige, der bei dem jeweiligen Betriebszustand des Schmitt-Triggers Strom leiten würde, dadurch abgeschaltet wird, daß die diesen Transistor mit Strom versorgende Stromquelle mittels der Schalteinrichtung kurzgeschlossen wird, derart, daß der Strom dieser Stromquelle nicht mehr durch diesen Transistor fließt sondern parallel an diesem Transistor vorbei geführt wird. In jedem Betriebszustand dieses Schmitt-Triggers fließen daher immer die Ströme beider Stromquellen, wobei immer der Strom einer der beiden Stromquellen durch einen der beiden Komparatoren fließt und der Strom der anderen Stromquelle an dem zugehörigen Komparator vorbei geleitet wird. Um dieses Vorbeileiten zu bewirken, wird ein weiterer Stromweg zwischen den beiden Polen der Energieversorgungsquelle leitend geschaltet. Bei diesem bekannten Schmitt-Trigger wird die Energieversorgungsquelle also permanent mit den Strömen der beiden Stromquellen und dem Strom durch den weiteren Stromweg belastet.

Es gibt Anwendungen, bei denen der Stromverbrauch ein sehr kritischer Faktor ist. In diesen Fällen sollte der Schmitt-Trigger so wenig Strom wie nur irgendwie möglich verbrauchen. Ein Beispiel sind batteriebetriebene Vorrichtungen, die über längere Zeit ruhen, deren Schmitt-Trigger aber trotzdem permanent in Betrieb sein muß, um jederzeit für die Feststellung von Eingangssignalwertwechseln bereit zu sein, auch wenn diese nur in größeren Zeitabständen auftreten.

Übliche Schmitt-Trigger benötigen dauernd Vorspannströme, die für die genannten Anwendungen viel zu hoch sind. Man könnte diese Vorspannströme durch die Verwendung von Widerständen mit großem Widerstandswert reduzieren. Bei der monolithischen Integration von Schmitt-Triggern führt dies jedoch zu Problemen. Große Widerstände benötigen viel Chip-Fläche und sind daher teuer.

Derzeit bekannte Präzisions-Schmitt-Trigger weisen Differenzverstärker auf, die einen bestimmten Vorspannstrom benötigen.

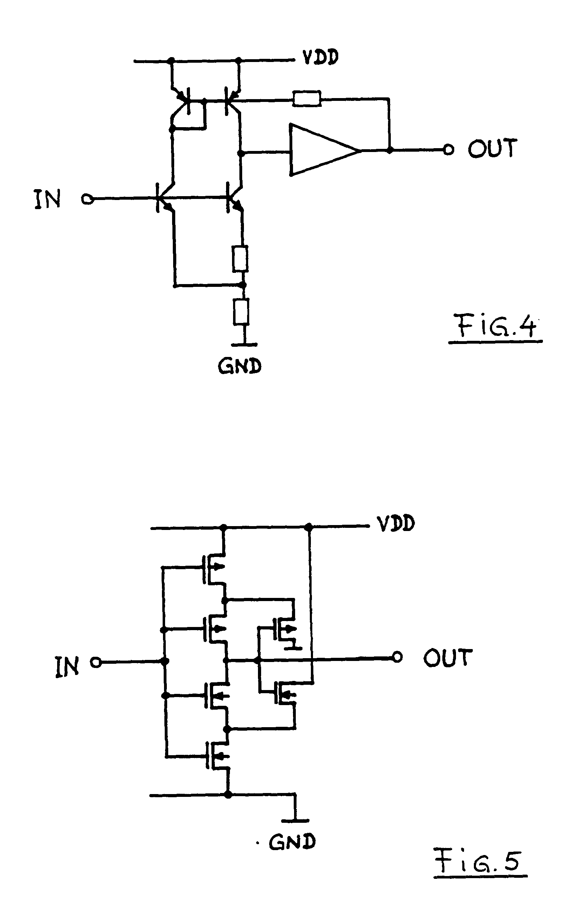

Eine Verringerung im Stromverbrauch erreicht man mit Bandgap-Schmitt-Triggern und mit MOS-Schmitt-Triggern. Beispiele solcher Schmitt-Trigger sind in **Fig. 4** bzw. **Fig. 5** gezeigt. Ein MOS-Schmitt-Trigger ist bekannt aus dem National Semiconductor (MOS Databook 1977, Seite 5-30). Da diese Schaltungen dem Fachmann bekannt sind, ist deren Erläuterung im einzelnen hier nicht erforderlich.

Bandgap-Schmitt-Trigger haben eine nur wenig temperaturabhängige Schaltschwelle von etwa 1,2 V. Sie beginnen aber bereits bei einem Eingangssignal weit unterhalb dieser Schaltschwelle Strom zu verbrauchen und tun dies auch oberhalb der Schaltschwelle. Das heißt, sie verbrauchen im größten Teil ihres Betriebsbereichs Strom.

MOS-Schmitt-Trigger der in **Fig. 5** gezeigten Art verbrauchen zwar Strom nur während des Umschaltens ihres Schaltzustandes. Sie sind aber stark von einer guten Anpassung der bei ihnen verwendeten P-Kanal-MOS und N-Kanal-MOS aneinander abhängig.

Da der Leitungsmechanismus von P-Kanal- und N-Kanal-MOS auf unterschiedlichen Ladungsträgertypen mit unterschiedlicher Ladungsträgerbeweglichkeit beruht, ist es um die Präzision derartiger MOS-Schmitt-Trigger schlecht bestellt. Außerdem sind sie relativ stark temperaturabhängig.

Mit der vorliegenden Erfindung wird ein Schmitt-Trigger verfügbar gemacht, der einerseits präzise arbeitet und andererseits einen sehr geringen Stromverbrauch aufweist, da er nur während des Umschaltens seiner Schaltzustände kurzzeitig Strom benötigt. Während der restlichen Zeiten ist er stromlos.

Dies wird bei einem Schmitt-Trigger der eingangs angegebenen Art dadurch erreicht, daß als erster Komparator ein Komparator vorgesehen ist, der beim Überschreiten des ersten Schwellenwertes in einen stromleitenden Zustand und beim Unterschreiten des ersten Schwellenwertes in einen stromlosen Zustand übergeht; daß als zweiter Komparator ein Komparator vorgesehen ist, der beim Unterschreiten des zweiten Schwellenwertes in einen stromleitenden Zustand und beim Überschreiten des zweiten Schwellenwertes in einen stromlosen Zustand übergeht; daß die Speicherschaltung bei einem Übergang des ersten Komparators in den stromleitenden Zustand in einen ersten Speicherzustand übergeht und bei einem Übergang des zweiten Komparators in den stromleitenden Zustand in einen zweiten Speicherzustand übergeht; daß die Abschalteinrichtung bei einem Übergang der Speicherschaltung in den ersten Speicherzustand die zweite Stromquelle einschaltet und die erste Stromquelle ausschaltet, so daß der erste Komparator nach seinem Übergang in den stromleitenden Zustand durch Ausschalten der ersten Stromquelle gleich wieder stromlos wird; und daß die Abschalteinrichtung bei einem Übergang der Speicherschaltung in den zweiten Speicherzustand die erste Stromquelle einschaltet und die zweite Stromquelle ausschaltet, so daß der zweite Komparator nach seinem Übergang in den stromleitenden Zustand durch Ausschalten der zweiten Stromquelle gleich wieder stromlos wird.

Da bei dem erfindungsgemäßen Schmitt-Trigger derjenige Komparator, der gerade in seinen leitenden Zustand geschaltet worden ist, unmittelbar nach Erreichen dieses Schaltzustandes abgeschaltet wird, vor diesem Abschalten das Erreichen dieses Schaltzustandes aber mittels der Speicherschaltung registriert und durch Speichern festgehalten wird, fließt außerhalb der kurzen Schaltzustandswechsel kein Strom. Da außerdem die Komparatoren mit Differenzverstärkern aufgebaut sind, kann man die Genauigkeit herkömmlicher Präzisions-Schmitt-Trigger erhalten.

Vorteilhafterweise kann man die Speicherschaltung durch eine bistabile Kippschaltung bilden, die dadurch, daß der erste Komparator in den leitenden Schaltzustand gelangt, in einen ersten Kippzustand und dadurch, daß der zweite Komparator in den leitenden Schaltzustand gelangt, in einen zweiten Kippzustand geschaltet wird. Bei einer bevorzugten Ausführungsform der Erfindung ist die bistabile Kippschaltung ein RS-Flipflop, dessen Setz-Eingang mit dem Ausgang des ersten Komparators und dessen Rücksetz-Eingang mit dem Ausgang des zweiten Komparators verbunden ist.

In besonders bevorzugter Weise steuert ein Ausgangssignal der Kippstufe bzw. des Flipflop das Stromlosschalten desjenigen Komparators, der nach einem Schaltzustandswechsel des Schmitt-Triggers in den leitenden Zustand gelangt ist. Die Kippstufe bzw. das Flipflop erfüllt somit eine Doppelaufgabe. Zum einen speichert sie den jeweiligen Schaltzustandswechsel, zum anderen steuert sie nach jedem Schaltzustandswechsel ein sofortiges Rückschalten des leitend gewordenen Komparators in den stromlosen Zustand.

Zu diesem Zweck kann die Abschalteinrichtung eine dem ersten Komparator zugeordnete erste steuerbare Schalteinrichtung zum Abschalten der ersten Stromquelle und damit zum Stromlosschalten des ersten Komparators und eine dem zweiten Komparator zugeordnete zweite steuerbare Schalteinrichtung zum Abschalten der zweiten Stromquelle und damit zum Stromlosschalten des zweiten Komparators aufweisen, die beide von dem Kippzustand der bistabilen Kippstufe steuerbar sind, derart, daß im ersten Kippzustand die erste Schalteinrichtung sperrend und die zweite Schalteinrichtung leitend und im zweiten Kippzustand die zweite Schalteinrichtung sperrend und die erste Schalteinrichtung leitend geschaltet sind.

Bei einer bevorzugten Ausführungsform der Erfindung weist jeder der beiden Komparatoren in der an sich aus der EP-A-0 107 189 bereits bekannten Art einen Differenzverstärker mit zwei Differenzeingängen, zwei Differenz ausgängen und einem Stromeingang sowie eine Stromspiegelschaltung mit einem Transistorzweig und einem Diodenzweig auf, wobei von den beiden Differenzeingängen ein erster mit dem Signaleingang und der zweite mit einer Referenzspannungsquelle verbunden ist, von den beiden Differenzausgängen einer mit einem Diodenzweig und der andere sowohl mit dem Transistorzweig als auch mit einem ersten bzw. mit einem zweiten Eingang der Speicherschaltung verbunden ist, die zugehörige Stromquelle zwischen den Stromeingang und einen Pol einer Spannungsversorgungsquelle geschaltet ist und der Transistorzweig und der Diodenzweig auf der nicht mit dem Differenzverstärker verbundenen Seite mit dem anderen Pol der Spannungsversorgungsquelle verbunden sind.

Bei jedem Komparator kann der Differenzverstärker mit Transistoren eines ersten Leitfähigkeitstyps und der Stromspiegel mit Transistoren des entgegengesetzten Leitfähigkeitstyps aufgebaut sein. Dabei kann die Stromquelle eines jeden Komparators einen Stromquellentransistor aufweisen, der vom gleichen Leitfähigkeitstyps wie die Transistoren des Differenzverstärkers ist.

Der Stromquellentransistor eines jeden Komparators kann gleichzeitig die steuerbare Schalteinrichtung bilden und sein Steueranschluß kann zu diesem Zweck mit einem Steuerausgang der Speicherschaltung verbunden sein. Die steuerbare Schalteinrichtung kann aber auch mit dem Stromquellentransistor in Reihe geschaltet sein. Alternativ kann sie mit dem Diodentransistor der Stromspiegelschaltung in Reihe geschaltet sein. Vorzugsweise ist die steuerbare Schalteinrichtung durch einen Schalttransistor gebildet.

Vorzugsweise ist der erfindungsgemäße Schmitt-Trigger monolithisch integriert, wobei sämtliche Transistoren durch MOS-Transistoren gebildet sind. Bei einer bevorzugten Ausführungsform sind die Transistoren des Differenzverstärkers und der die steuerbare Schalteinrichtung bildende Transistor des ersten Komparators und die Transistoren der Stromspiegelschaltung des zweiten Komparators durch N-Kanal-MOS-Transistoren und die Transistoren des Differenzverstärkers und der die steuerbare Schalteinrichtung bildende Transistor des zweiten Komparators und die Transistoren der Stromspiegelschaltung des ersten Komparators durch P-Kanal-MOS-Transistoren gebildet, sind die Stromspiegelschaltung des ersten Komparators und der Stromquellentransistor des zweiten Komparators mit dem positiven Pol der Spannungsversorgungsquelle und die Stromspiegelschaltung des zweiten Komparators und der Stromquellentransistor des ersten Komparators mit dem negativen Pol der Spannungsversorgungsquelle verbunden, weist das RS-Flipflop in bekannter Weise einen Q-Anschluß und einen Q̄-Anschluß auf, sind die Steueranschlüsse der die steuerbaren Schalteinrichtungen bildenden Transistoren gemeinsam mit dem Q̄-Ausgangsanschluß des RS-Flipflop verbunden und ist zwischen den Ausgang des zweiten Komparators und den Rücksetzeingang des RS-Flipflop ein Inverter geschaltet.

Um zum Zweck der Erzeugung einer Umschalthysterese des Schmitt-Triggers für beide Komparatoren einen unterschiedlichen Schaltschwellenwert zu bewirken, können die zweiten Differenzeingänge der Differenzverstärker der beiden Komparatoren mit Referenzspannungsquellen unterschiedlichen Referenzspannungswertes verbunden sein. Die zweiten Differenzeingänge können aber auch mit derselben Referenzspannungsquelle verbunden sein. In diesem Fall werden die unterschiedlichen Schaltschwellen der beiden Komparatoren durch komparatorinterne Offset-Spannungen gebildet. Diese können durch unterschiedliche Auslegung der Differenzverstärker-Transistoren, im Fall von MOS-Transistoren insbesondere hinsichtlich ihrer Kanalbreiten, erreicht werden.

Die Erfindung wird nun anhand bevorzugter Ausführungsformen näher erläutert. In den zugehörigen Zeichnungen zeigen:

Fig. 1 ein Blockschaltbild einer ersten Ausführungsform eines erfindungsgemäßen Schmitt-Triggers;

Fig. 2 ein Blockschaltbild einer zweiten Ausführungsform eines erfindungsgemäßen Schmitt-Triggers;

Fig. 3 ein detailliertes Schaltbild der in Fig. 2 gezeigten Ausführungsform;

Fig. 4 einen Bandgap-Schmitt-Trigger bekannter Art und

Fig. 5 einen MOS-Schmitt-Trigger bekannter Art.

Der in Fig. 4 gezeigte Bandgap-Schmitt-Trigger ist von bekannter Bauart und bedarf daher keiner weiteren Erläuterungen als der bereits gegebenen. Das gleiche gilt für den in Fig. 5 gezeigten bekannten MOS-Schmitt-Trigger. Beide Schmitt-Trigger weisen eine Hysterese auf. Bei dem Bandgap-Schmitt-Trigger wird die Hysterese durch eine Rückkopplung vom Ausgang des Operationsverstärkers zum Stromspiegel erreicht. Beim MOS-Schmitt-Trigger erreicht man die Hysterese durch die Rückkopplung vom Ausgang über einen P-Kanal-MOS zum Verbindungspunkt zwischen den beiden oberen P-Kanal-MOS und über einen N-Kanal-MOS zum Verbindungspunkt zwischen den beiden unteren N-Kanal-MOS der Inverterstufe.

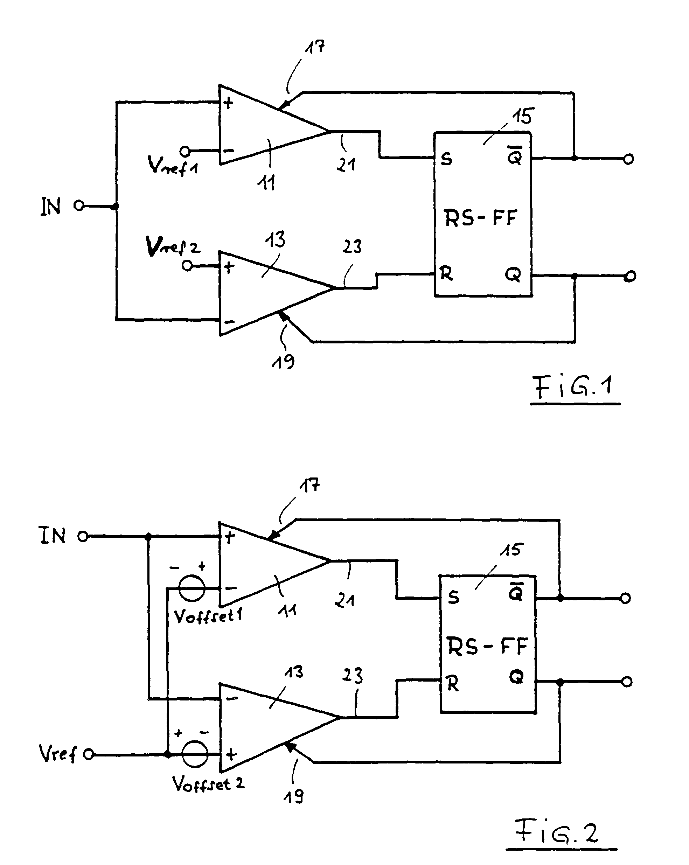

Eine erste Ausführungsform eines erfindungsgemäßen Schmitt-Triggers zeigt Fig. 1 in Blockschaltbilddarstellung. Diese umfaßt einen ersten und einen zweiten Komparator, im folgenden "oberer Komparator 11" bzw. "unterer Komparator 13" genannt, sowie ein RS-Flipflop 15. Ein nicht invertierender Eingang "+" des oberen Komparators 11 und ein invertierender Eingang "-" des unteren Komparators 13 sind gemeinsam mit einem Signaleingang "IN" verbunden. Ein invertierender Eingang "-" des oberen Komparators 11 ist an eine erste Referenzspannungsquelle Vref1 und ein nicht invertierender Eingang "+" des unteren Komparators 13 ist an eine zweite Referenzspannungsquelle Vref2 angeschlossen. Die Ausgänge 21 bzw. 23 der beiden Komparatoren 11 und 13 sind mit einem Setz-Eingang S bzw. mit einem Rücksetz-Eingang R des RS-Flipflop 15 verbunden. Ein Q̄-Ausgang des RS-Flipflop 15 ist mit einem Sperrsteuereingang 17 des oberen Komparators 11 verbunden. Ein Q-Ausgang des RS-Flipflop 15 ist mit einem Sperrsteuereingang 19 des unteren Komparators 13 verbunden. Die Referenzspannung Vref2 ist niedriger als die Referenzspannung Vref1.

Der obere Komparator 11 ist unterhalb des durch seine Referenzspannung Vref1 bestimmten Schwellenwertes stromlos. Er gelangt erst beim Überschreiten seines Schwellenwertes in einen leitenden und damit stromverbrauchenden Schaltzustand. In entgegengesetzter oder gegenläufiger Weise ist der untere Komparator 13 oberhalb des durch seine Referenzspannung Vref2 bestimmten Schwellenwertes stromlos und gelangt durch das Unterschreiten seines Schwellenwertes in einen leitenden und damit stromverbrauchenden Schaltzustand. Über den Sperrsteuereingang 17 bzw. 19 kann der leitende Komparator 11 bzw. 13 in einen stromlosen Zustand geschaltet werden.

Nun zur Arbeitsweise des in Fig. 1 gezeigten Schmitt-Triggers.

Zunächst sei angenommen, daß das Eingangssignal am Eingang IN unterhalb Vref2 liegt. Bei einem solchen Eingangsspannungswert ist der obere Komparator 11 von Haus aus stromlos und ist der untere Komparator 13 stromlos geschaltet. Beim Anstieg des Eingangssignals auf den Spannungswert von Vref1 schaltet der obere Komparator 11 in den stromleitenden Schaltzustand um, wobei sein Ausgang einen hohen Signalwert annimmt. Dadurch wird das RS-Flipflop 15 umgeschaltet, so daß es an seinem Ausgang $\overline{Q}$ einen entsprechenden Signalwert einnimmt. Dieser Schaltzustand des oberen Komparators 11 bleibt gespeichert, bis das RS-Flipflop 15 über seinen Rücksetzeingang R in seinen anderen Schaltzustand zurückgebracht wird. Das Auftreten dieses Signalwerts am Ausgang $\overline{Q}$ bewirkt außerdem über den Sperrsteuereingang 17, daß der obere Komparator 11 in einen stromlosen Zustand geschaltet wird. Danach sind wieder beide Komparatoren 11 und 13 stromlos und damit ohne Stromverbrauch. Das RS-Flipflop 15 kann in bekannter Weise in CMOS-Technik realisiert werden, so daß auch seitens des RS-Flipflop 15 außerhalb der Umschaltvorgänge kein Stromverbrauch auftritt.

Unterschreitet danach das Eingangssignal irgendwann den Spannungswert von Vref2, schaltet der zuvor stromlose untere Komparator 13 in einen stromleitenden Schaltzustand um, mit gleichzeitigem Übergang seines Ausgangs zu einem hohen Signalwert. Dadurch wird das Rs-Flipflop 15 in seinen anderen Schaltzustand gebracht. Der dabei am Ausgang Q auftretende entsprechende Signalwert schaltet den unteren Komparator 13 über dessen Sperrsteuereingang 19 in einen stromlosen Zustand. Das vorausgehende Umschalten des unteren Komparators 13 in den stromleitenden Zustand bleibt im RS-Flipflop 15 gespeichert.

**Fig. 2** zeigt eine Blockdarstellung einer zweiten Ausführungsform eines erfindungsgemäßen Schmitt-Triggers, die der ersten Ausführungsform gemäß **Fig. 1** sehr ähnlich ist. Daher werden für gleiche Komponenten auch gleiche Bezugszeichen verwendet. Ein Unterschied zur ersten Ausführungsform besteht lediglich insofern, als für beide Komparatoren 11 und 13 nur eine einzige Referenzspannungsquelle Vref vorgesehen ist. Die unterschiedlichen Umschalt-Schwellenwerte für die beiden Komparatoren 11, 13 werden dabei durch unterschiedliche interne Offset-Spannungen Voffset1 und Voffset2 der Komparatoren 11 bzw. 13 erzeugt. Die Arbeitsweise in der zweiten Ausführungsform stimmt ansonsten mit derjenigen der ersten Ausführungsform überein.

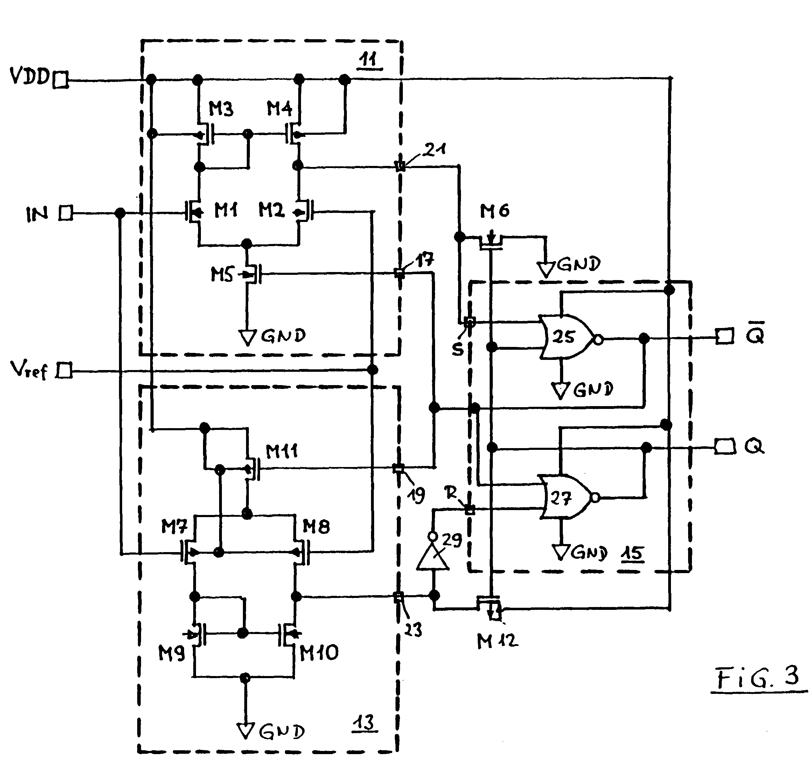

Ein ausführliches Schaltbild der zweiten Ausführungsform ist in **Fig. 3** gezeigt. Dabei weist jeder Komparator 11, 13 einen Differenzverstärker, einen Stromspiegel und einen sperrbaren Stromquellentransistor auf.

Der Differenzverstärker des oberen Komparators 11 enthält N-Kanal-MOS M1 und M2, deren Gateanschlüsse mit dem Signaleingang IN bzw. mit der gemeinsamen Referenzspannungsquelle Vref verbunden sind. Der Stromspiegel des oberen Komparators 11 umfaßt einen als Diode geschalteten P-Kanal-MOS M3 im Diodenzweig und einen P-Kanal-MOS M4 im Transistorzweig. Die beiden MOS M1 und M2 des Differenzverstärkers sind über den Diodenzweig bzw. den Transistorzweig des Stromspiegels mit dem positiven Pol VDD einer Spannungsversorgungsquelle verbunden. M1 und M2 sind gemeinsam über einen Stromquellentransistor M5 in Form eines N-Kanal-MOS mit dem negativen Pol GND der Spannungsversorgungsquelle verbunden. Eine interne Offset-Spannung zur Festlegung des Schwellenwertes des oberen Komparators 11 ist durch unterschiedliche Dimensionierung der Kanalweiten der beiden Transistoren M1 und M2 des Differenzverstärkers gegeben. Die Kanalweite von M2 ist beispielsweise doppelt so groß wie die von M1.

Der untere Komparator 13 weist die gleiche Schaltungsstruktur wie der obere Komparator 11 auf. Er unterscheidet sich vom oberen Komparator 11 lediglich dadurch, daß die Transistoren M7 und M8 seines Differenzverstärkers, die Transistoren M9 und M10 im Dioden- bzw. Transistorzweig seines Stromspiegels und sein Stromquellentransistor M11 von einem Kanaltyp sind, der dem des entsprechenden Transistors des oberen Komparators 11 je entgegengesetzt ist, und daß sein Stromquellentransistor M11 an VDD und sein Stromspiegel M9, M10 an GND angeschlossen sind.

Ein Ausgang 21 des oberen Komparators 11 ist mit dem S-Eingang und ein Ausgang 23 des unteren Komparators 13 ist mit dem R-Eingang des RS-Flipflop 15 verbunden. Das RS-Flipflop 15 umfaßt bei der dargestellten Ausführungsform in bekannter Weise zwei in CMOS-Technik aufgebaute NOR-Schaltungen 25 und 27, deren erste Eingänge den S-Eingang bzw. den R-Eingang bilden und deren Ausgänge $\overline{Q}$ bzw. Q überkreuz auf einen zweiten Eingang der je anderen NOR-Schaltung rückgekoppelt sind zwischen den Ausgang 23 und den R-Eingang ist ein Inverter 29 geschaltet.

Zwischen den Ausgang 21 des oberen Komparators 11 und GND ist ein N-Kanal-MOS M6 geschaltet, dessen Gateanschluß mit dem zweiten Eingang der NOR-Schaltung 25 verbunden ist. Zwischen den Ausgang 23 des unteren Komparators 13 und VDD ist ein P-Kanal-MOS M12 geschaltet, dessen Gateanschluß mit dem Ausgang der NOR-Schaltung 27 verbunden ist.

Bei der nachfolgenden Erläuterung der Arbeitsweise des in **Fig. 3** gezeigten Schmitt-Triggers wird zunächst der obere Komparator 11 betrachtet.

Befindet sich das über den Eingang IN zugeführte Eingangssignal oberhalb des durch Vref und Voffset1 bestimmten Schwellenwertes, leiten M1, M3, M4 und sperrt M2. Ist M5 über seinen Gateanschluß leitend geschaltet, fließt zwischen VDD und GND ein Strom über M3, M1 und M5.

Gelangt das Eingangssignal unter den Schwellenwert des oberen Komparators 11, sind M1, M3 und M4 gesperrt und leitet M2 solange, bis die Eingangskapazität der an den Ausgang 21 des oberen Komparators 11 angeschlossen Schaltungsanordnung entladen ist. Aufgrund der niedrigen beteiligten Kapazitäten hört daher der Stromfluß durch M2 schnell auf. Danach ist der obere Komparator 11 stromlos.

Der untere Komparator 13 hat ein zum oberen Komparator 11 gegenläufiges Verhalten. Weist das Eingangssignal einen Spannungswert auf, der unterhalb des durch Vref und Voffset2 bestimmten Schwellenwertes des unteren Komparators 13 liegt, leiten M7, M9, M10 und sperrt M8. Ist M11 leitend geschaltet, kann zwischen VDD und GND ein Strom über M7, M9 und M11 fließen. Überschreitet von da aus die Eingangsspannung den Schwellenwert des unteren Komparators 13, sperren M7, M9 und M10 und leitet M8 Strom, bis die Kapazität der an den Ausgang 23 des unteren Komparators 13 angeschlossene Schaltungsanordnung entladen ist. Dies nimmt nur kurze Zeit in Anspruch. Danach ist der untere Komparator 13 stromlos.

Bei der nun folgenden Betrachtung der Arbeitsweise der gesamten in **Fig. 3** gezeigten Schaltungsanordnung wird die Annahme gemacht, daß sich das Eingangssignal gerade unterhalb des Schwellenwertes des unteren Komparators 13 befindet. Bei diesem Eingangssignalwert ist der obere Komparator 11 stromlos. Aber auch der untere Komparator 13 ist stromlos. Denn bei dem vorausgegangenen Unterschreiten des unteren Schwellenwertes des Schmitt-Triggers, der durch den Schwellenwert des unteren Komparators 13 gebildet wird, ist das RS-Flipflop 15 in seinen Rücksetz-Zustand gebracht worden, den es seither speichert und daher noch innehat. Der im Rücksetz-Zustand am $\overline{Q}$-Ausgang des RS-Flipflop 15 auftretende Logikspannungswert hält den Stromquellentransistor M11 des unteren Komparators 13 gesperrt.

Dieses Signal am $\overline{Q}$-Ausgang hält gleichzeitig den Stromquellentransistor M5 des oberen Komparators 11 im Einschaltzustand. Steigt nun der Spannungswert des Eingangssignals von unterhalb des unteren Schwellenwertes des Schmitt-Triggers bis über dessen oberen Schwellenwert an, der durch den Schwellenwert des oberen Komparators 11 gebildet wird, gelangt der obere Komparator 11 von seinem stromlosen Zustand in seinen stromleitenden Zustand. Aufgrund dieses Umschaltens gibt der obere Komparator 11 an seinem Ausgang 21 einen hohen Spannungswert ab, durch welchen das RS-Flipflop 15 in seinen Setz-Zustand umschaltet. Dadurch gelangt der Q-Ausgang des RS-Flipflop 15 zum entgegengesetzten Logikspannungswert. Dieser Spannungswert führt dazu, daß der Stromquellentransistor M5 des oberen Komparators 11 gesperrt wird, während der Stromquellentransistor M11 des unteren Komparators 13 in den leitenden Zustand versetzt wird. Der obere Komparator 11 wird dadurch stromlos gehalten, während der untere Komparator 13 für ein Umschalten seines Schaltzustandes bei einem nachfolgenden Unterschreiten des unteren Schwellenwertes des Schmitt-Triggers durch das Eingangssignal vorbereitet ist.

Aufgrund der zuvor beschriebenen Arbeitsweise gerät der erfindungsgemäße Schmitt-Trigger immer nur während des Überschreitens des oberen Schwellenwertes bzw. des Unterschreitens des unteren Schwellenwertes für eine kurze Zeitdauer in einen leitenden und damit stromverbrauchenden Zustand. Außerhalb dieser jeweiligen Umschaltzeitdauer findet kein Stromverbrauch statt, weil immer einer der beiden Komparatoren von Haus aus im stromlosen Zustand ist und der jeweils andere Komparator durch Sperren seines Stromquellentransistors im stromlosen Zustand gehalten wird.

Das RS-Flipflop 15 hat eine Doppelfunktion. Einerseits speichert es den Schaltzustand desjenigen Komparators, der jeweils als letzter in den leitenden Zustand gelangt ist. Andererseits sorgt es dafür, daß der leitend gewordene Komparator gleich wieder in einen stromlosen Zustand gelangt.

Die Transistoren M6 und M12 sind aus Sicherheitsgründen vorgesehen, um Leckstrom-Auswirkungen vorzubeugen. Diese Transistoren halten die Logik-Potentiale an den Eingängen des RS-Flipflop 15 auch beim Auftreten von Leckströmen aufrecht.

Bei der in **Fig. 3** gezeigten Ausführungsform befindet sich der Ausgang 21 des oberen Komparators 11 dann, wenn das Eingangssignal den oberen Schwellenwert des Schmitt-Triggers überschritten hat, auf einem hohen Logikspannungswert H. Beim Übergang des Ausgangs 21 vom niedrigen Logikspannungswert L zum hohen Logikspannungswert H schaltet das RS-Flipflop 15 um, so daß dessen Ausgang $\overline{Q}$ auf L geht. Dies schaltet M5 aus und M11 ein. Gleichzeitig geht der Ausgang Q des RS-Flipflop 15 auf H. Dies führt zum Einschalten des als N-Kanal-MOS ausgebildeten Transistors M6. Damit wird sichergestellt, daß das RS-Flipflop 15 nicht durch statische Ladung zurückgeschaltet werden kann. Man beachte, daß der Ausgang 21 hochohmig geworden ist.

Fällt das Eingangssignal ab, befindet sich jedoch noch oberhalb des Schwellenwertes des unteren Komparators 13, sind M7, M9 und M10 ausgeschaltet, während M8 und M11 eingeschaltet sind. Der Ausgang 23 des unteren Komparators 13 liegt somit auf H, so daß der Ausgang des Inverters 29 auf L liegt. Das RS-Flipflop 15 bleibt daher rückgesetzt. Unterschreitet das Eingangssignal von da aus den Schwellenwert des unteren Komparators 13, werden M7, M9 und M10 leitend und sperrt M8. Ausgang 23 geht daher auf L über und der Ausgang des Inverters 29 gelangt auf H. Dadurch wird das RS-Flipflop 15 rückgesetzt. Der Ausgang $\overline{Q}$ wird daher auf H umgeschaltet, so daß M11 sperrend und M5 leitend geschaltet wird. Gleichzeitig geht der Ausgang Q auf L über, so daß der als P-Kanal-MOS ausgebildete Transistor M12 leitend geschaltet wird. Dadurch wird der nun hochohmige Ausgang 23 gegen statische Ladungen geschützt.

**Patentansprüche**

1. Schmitt-Trigger mit einer Komparator-Schaltung, die einem über einen Signaleingang (IN) zugeführten Eingangssignal schwellenabhängig einen niedrigen oder einen hohen Ausgangssignalwert zuordnet, mit:

   a) zwei bezüglich des Signaleingangs (IN) parallel geschalteten Komparatoren (11, 13), wobei einem ersten (11) der beiden Komparatoren ein oberer Schwellenwert (Vref1) und dem zweiten (13) der beiden Komparatoren ein darunter liegender unterer Schwellenwert (Vref2) zugeordnet ist;

   b) zwei Stromquellen (M5, M11), von denen eine erste (M5) den ersten Komparator (11) und eine zweite (M11) den zweiten Komparator (13) mit Strom versorgt;

   c) einer Speicherschaltung (15), deren Speicherwert von der Lage des Eingangssignals bezüglich der beiden Schwellenwerte (Vref1, Vref2) abhängt; und

   d) einer Abschalteinrichtung, die dann, wenn das Eingangssignal den ersten Schwellenwert (Vref1) überschreitet, den ersten Komparator (11) stromlos schaltet, und die dann, wenn das Eingangssignal den zweiten Schwellenwert (Vref2) unterschreitet, den zweiten Komparator (13) stromlos schaltet;

**dadurch gekennzeichnet,**

   e) daß als erster Komparator (11) ein Komparator vorgesehen ist, der beim Überschreiten des ersten Schwellenwertes (Vref1) in einen stromleitenden Zustand und beim Unterschreiten des ersten Schwellenwertes in einen stromlosen Zustand übergeht;

   f) daß als zweiter Komparator (13) ein Komparator vorgesehen ist, der beim Unterschreiten des zweiten Schwellenwertes (Vref2) in einen stromleitenden Zustand und beim Überschreiten des zweiten Schwellenwertes (Vref2) in einen stromlosen Zustand übergeht;

   g) daß die Speicherschaltung (15) bei einem Übergang des ersten Komparators (11) in den stromleitenden Zustand in einen ersten Speicherzustand übergeht und bei einem Übergang des zweiten Komparators (13) in den stromleitenden Zustand in einen zweiten Speicherzustand übergeht;

   h) daß die Abschalteinrichtung bei einem Übergang der Speicherschaltung (15) in den ersten Speicherzustand die zweite Stromquelle (M11) einschaltet und die erste Stromquelle (M5) ausschaltet, so daß der erste Komparator (11) nach seinem Übergang in den stromleitenden Zustand durch Ausschalten der ersten Stromquelle (M5) gleich wieder stromlos wird; und

   i) daß die Abschalteinrichtung bei einem Übergang der Speicherschaltung (15) in den zweiten Speicherzustand die erste Stromquelle (M5) einschaltet und die zweite Stromquelle (M11) ausschaltet, so daß der zweite Komparator (13) nach seinem Übergang in den stromleitenden Zustand durch Ausschalten der zweiten Stromquelle (M11) gleich wieder stromlos wird.

2. Schmitt-Trigger nach Anspruch 1, **dadurch gekennzeichnet,**

   daß die Speicherschaltung durch eine bistabile Kippschaltung (15) gebildet ist, die beim Übergang des ersten Komparators (11) in den stromleitenden Zustand in einen ersten Kippzustand und beim Übergang des zweiten Komparators (13) in den stromleitenden Zustand, in einen zweiten Kippzustand geschaltet wird.

3. Schmitt-Trigger nach Anspruch 2, **dadurch gekennzeichnet,**

   daß die bistabile Kippschaltung ein RS-Flipflop (15) aufweist, dessen Setz-Eingang (S) mit dem Ausgang (21) des ersten Komparators (11) und dessen Rücksetz-Eingang (R) mit dem Ausgang (23) des zweiten Komparators (13) verbunden ist.

4. Schmitt-Trigger nach einem der Ansprüche 1 bis 3, **dadurch gekennzeichnet,**

   - daß die Abschalteinrichtung eine der ersten Stromquelle (M5) zugeordnete erste steuerbare Schalteinrichtung zum Ausschalten der ersten Stromquelle (M5) und eine der zweiten Stromquelle (M11) zugeordnete zweite steuerbare Schalteinrichtung zum Ausschalten der zweiten Stromquelle (M11) aufweist, und

   - daß beide Schalteinrichtungen von dem Kippzustand der bistabilen Kippstufe (15) steuerbar sind, derart, daß im ersten Kippzustand die erste Schalteinrichtung die erste Stomquelle (M5) ausschaltet und die zweite Stromquelle (M11) einschaltet und im zweiten Kippzustand die zweite Schalteinrichtung die zweite Stromquelle (M11) ausschaltet und die erste Stromquelle (M5) einschaltet.

5. Schmitt-Trigger nach einen der Ansprüche 1 bis 4, **dadurch gekennzeichnet,**

daß jeder der beiden Komparatoren (11,13) aufweist:

- einen Differenzverstärker (M1, M2; M7, M8) mit zwei Differenzeingängen, zwei Differenzausgängen und einem Stromeingang, und
- eine Stromspiegelschaltung (M3, M4; M9, M10) mit einem Transistorzweig (M4; M10) und einem Diodenzweig (M3; M9),

wobei

- von den beiden Differenzeingängen ein erster mit dem Signaleingang (IN) und der zweite mit einer Referenzspannungsquelle (Vref) verbunden ist,
- von den beiden Differenzausgängen einer mit dem Diodenzweig (M3; M9) und der andere sowohl mit dem Transistorzweig (M4; M10) als auch mit einem ersten (S) bzw. mit einem zweiten (R) Eingang der Speicherschaltung (15) verbunden ist,
- jede der beiden Stromquellen (M5; M11) zwischen den Stromeingang und einen Pol (VDD,GND) einer Spannungsversorgungsquelle geschaltet ist, und
- der Transistorzweig (M4; M10) und der Diodenzweig (M3; M9) auf der nicht mit dem Differenzverstärker verbundenen Seite mit dem anderen Pol (GND,VDD) der Spannungsversorgungsquelle verbunden sind.

6. Schmitt-Trigger nach Anspruch 5,
**dadurch gekennzeichnet,**

daß bei jedem Komparator (11, 13) der Differenzverstärker mit Transistoren (M1, M2; M7, M8) eines ersten Leitfähigkeitstyps und der Stromspiegel mit Transistoren (M3, M4; M9, M10) des entgegengesetzten Leitfähigkeitstyps aufgebaut ist.

7. Schmitt-Trigger nach Anspruch 6,
**dadurch gekennzeichnet,**

daß die Stromquelle eines jeden Komparators (11, 13) einen Stromquellentransistor (M5, M11) aufweist, der vom gleichen Leitfähigkeitstyp wie die Transistoren (M1, M2; M7, M8) des Differenzverstärkers ist.

8. Schmitt-Trigger nach Anspruch 7,
**dadurch gekennzeichnet,**

daß der Stromquellentransistor (M5; M11) eines jeden Komparators (11, 13) gleichzeitig die steuerbare Schalteinrichtung bildet und sein Steueranschluß zu diesem Zweck mit einem Steuerausgang (Q̄) der Speicherschaltung (15) verbunden ist.

9. Schmitt-Trigger nach Ansprüchen 4 und 5 oder 4 und Anspruch 6 oder 7,
**dadurch gekennzeichnet,**

daß die steuerbare Schalteinrichtung mit dem Stromquellentransistor (M5, M11) in Reihe geschaltet ist.

10. Schmitt-Trigger nach Ansprüche 4 und 5 und Anspruch 6 oder 7,
**dadurch gekennzeichnet,**

daß die steuerbare Schalteinrichtung dem Diodentransistor (M3; M9) der Stromspiegelschaltung in Reihe geschaltet ist.

11. Schmitt-Trigger nach Anspruch 9 oder 10,
**dadurch gekennzeichnet,**

daß die steuerbare Schalteinrichtung durch einen Schalttransistor (M5; M11) gebildet ist.

12. Schmitt-Trigger nach einem der Ansprüche 3 bis 11,
**dadurch gekennzeichnet,**

daß das RS-Flipflop (15) durch zwei kreuzweise aufeinander rückgekoppelte NOR-Schaltungen (25, 27) gebildet ist.

13. Schmitt-Trigger nach einem der Ansprüche 5 bis 12,
**dadurch gekennzeichnet,**

daß sämtliche Transistoren durch MOS-Transistoren gebildet sind.

14. Schmitt-Trigger nach Anspruch 13 in Verbindung mit einem der Ansprüche 8 bis 12,
**dadurch gekennzeichnet,**

- daß die Transistoren (M1, M2) des Differenzverstärkers des ersten Komparators (11) und der die erste Stromquelle bildende erste Stromquellentransistor (M5) und die Transistoren (M9, M10) der Stromspiegelschaltung des zweiten Komparators (13) durch N-Kanal-MOS-Transistoren und die Transistoren (M7, M8) des Differenzverstärkers des zweiten Komparators (13) und der die zweite Stromquelle bildende zweite Stromquellentransistor (M11) und die Transistoren (M3; M4) der Stromspiegelschaltung des ersten Komparators (11) durch P-Kanal-MOS-Transistoren gebildet sind,

- daß die Stromspiegelschaltung (M3, M4) des ersten Komparators (11) und der zweite Stromquellentransistor (M11) mit dem positiven Pol (VDD) der Spannungsversorgungsquelle und die Stromspiegelschaltung (M9, M10) des zweiten Komparators (13) und der erste Stromquellentransistor (M5) mit dem negativen Pol (GND) der Spannungsversorgungsquelle verbunden sind,
- daß das RS-Flipflop (15) in bekannter Weise einen Q-Ausgangsanschluß und einen $\bar{Q}$-Ausgangsanschluß aufweist,
- daß die Steueranschlüsse der die steuerbaren Schalteinrichtungen bildenden Transistoren (M5, M11) gemeinsam mit dem $\bar{Q}$-Ausgangsanschluß des RS-Flipflop (15) verbunden sind, und
- daß zwischen den Ausgang (23) des zweiten Komparators (13) und den Rücksetzeingang (R) des RS-Flipflop (15) ein Inverter (29) geschaltet ist.

15. Schmitt-Trigger nach einem der Ansprüche 5 bis 14,
**dadurch gekennzeichnet,**

daß die zweiten Differenzeingänge der Differenzverstärker der beiden Komparatoren (11, 13) mit Referenzspannungsquellen (Vref1, Vref2) unterschiedlichen Referenzspannungswertes verbunden sind.

16. Schmitt-Trigger nach einem der Ansprüche 5 bis 14,
**dadurch gekennzeichnet,**

daß die zweiten Differenzeingänge der Differenzverstärker der beiden Komparatoren (11, 13) mit derselben Referenzspannungsquelle (Vref) verbunden sind und daß die unterschiedlichen Schaltschwellen der beiden Komparatoren durch komparatorinterne Offset-Spannungen gebildet sind.

17. Schmitt-Trigger nach Anspruch 16,
**dadurch gekennzeichnet,**

daß die komparatorinternen Offset-Spannungen durch unterschiedliche Auslegung der Differenzverstärker-Transistoren (M1, M2; M7, M8), im Fall von MOS-Transistoren insbesondere hinsichtlich ihrer Kanalbreiten, erreicht werden.

**Claims**

1. A Schmitt trigger having a comparator circuit which, responsive to thresholds, associates a low or a high output signal value with an input signal supplied via a signal input (IN), comprising

a) two comparators (11, 13) connected in parallel with respect to the signal input (IN), a first one (11) of said two comparators having an upper threshold value (Vref1) associated therewith and the second one (13) of said two comparators having a lower threshold value (Vref2) associated therewith, which is lower than said upper threshold value;
b) two current sources (M5, M11), a first one (M5) of which supplies current to the first comparator (11) and a second one (M11) of which supplies current to the second comparator (13);
c) a memory circuit (15) whose memory value is dependent on the position of the input signal with respect to the two threshold values (Vref1, Vref2); and
d) a deactivating means which, when the input signal exceeds the first threshold value (Vref1), switches the first comparator (11) to the currentless state and, when the input signal falls below the second threshold value (Vref2), switches the second comparator (13) to the currentless state;

characterized in

e) that as said first comparator (11) there is provided a comparator which, when the input signal exceeds the first threshold value (Vref1), changes to a current conducting state and, when the input signal falls below the first threshold value, changes to a currentless state;
f) that as said second comparator (13) there is provided a comparator which, when the input signal falls below the second threshold value (Vref2), changes to a current conducting state and, when the input signal exceeds the second threshold value (Vref2), changes to a currentless state;
g) that the memory circuit (15) changes to a first memory state when the first comparator (11) changes to the current conducting state and changes to a second memory state when the second comparator (13) changes to the current conducting state;
h) that the deactivating means, when the memory circuit (15) changes to the first memory state, switches on the second current source (M11) and switches off the first current source (M5) so that the first comparator (11), after having changed to the current conducting state, immediately becomes currentless again by deactivation of the first current source (M5); and

i) that the deactivating means, when the memory circuit (15) changes to the second memory state, switches on the first current source (M5) and switches off the second current source (M11) so that the second comparator (13), after having changed to the current conducting state, immediately becomes currentless again by deactivation of the second current source (M11).

2. A Schmitt trigger according to claim 1, characterized in that the memory circuit is constituted by a bistable multivibrator circuit (15) which is switched to a first state when the first comparator (11) changes to the current conducting state and is switched to a second state when the second comparator (13) changes to the current conducting state.

3. A Schmitt trigger according to claim 2, characterized in that the bistable multivibrator circuit comprises an RS flipflop (15) whose setting input (S) is connected to the output (21) of the first comparator (11) and whose resetting input (R) is connected to the output (23) of the second comparator (13).

4. A Schmitt trigger according to any one of claims 1 to 3, characterized in

   - that the deactivating means comprises a first controllable switching means associated with the first current source (M5) for switching off the first current source (M5) and a second controllable switching means associated with the second current source (M11) for switching off the second current source (M11), and
   - that both switching means are controllable by the state of the bistable multivibrator circuit (15) such that, in the first state, the first switching means switches off the first current source (M5) and switches on the second current source (M11), and in the second state, the second switching means switches off the second current source (M11) and switches on the first current source (M5).

5. A Schmitt trigger according to any one of claims 1 to 4, characterized in that each of said two comparators (11, 13) comprises:

   - a differential amplifier (M1, M2; M7, M8) having two differential inputs, two differential outputs and a current input, and
   - a current mirror circuit (M3, M4; M9, M10) having a transistor branch (M4; M10) and a diode branch (M3; M9),
   - a first one of said two differential inputs being connected to the signal input (IN) and the second one being connected to a reference voltage source (Vref),
   - one of said two differential outputs being connected to the diode branch (M3; M9) and the other one being connected both to the transistor branch (M4; M10) and to a first (S) and a second (R) input, respectively, of the memory circuit (15),
   - each one of the two current sources (M5; M11) being connected between the current input and a pole (VDD, GND) of a voltage supply source, and
   - the transistor branch (M4; M10) and the diode branch (M3; M9), on the side not connected to the differential amplifier, being connected to the other pole (GND, VDD) of the voltage supply source.

6. A Schmitt trigger according to claim 5, characterized in that in each comparator (11, 13) the differential amplifier is composed with transistors (M1, M2; M7, M8) of a first conductivity type and the current mirror is composed with transistors (M3, M4; M9, M10) of the opposite conductivity type.

7. A Schmitt trigger according to claim 6, characterized in that the current source of each comparator (11, 13) has a current source transistor (M5, M11) of the same conductivity type as the transistors (M1, M2; M7, M8) of the differential amplifier.

8. A Schmitt trigger according to claim 7, characterized in that the current source transistor (M5; M11) of each comparator (11, 13) constitutes at the same time the controllable switching means, and its control terminal is connected for this purpose to a control output ($\overline{Q}$) of the memory circuit (15).

9. A Schmitt trigger according to claims 4 and 5 or 4 and claims 6 or 7, characterized in that the controllable switching means is connected in series with the current source transistor (M5, M11).

10. A Schmitt trigger according to claims 4 and 5 and claims 6 or 7, characterized in that the controllable switching means is connected in series with the diode transistor (M3; M9) of the current mirror circuit.

11. A Schmitt trigger according to claim 9 or 10, characterized in that the controllable switching means is constituted by a switching transistor (M5; M11).

**12.** A Schmitt trigger according to any one of claims 3 to 11,
characterized in that the RS flipflop (15) is constituted by two NOR circuits (25, 27) fedback to each other in crossing manner.

**13.** A Schmitt trigger according to any one of claims 5 to 12,
characterized in that all transistors are constituted by MOS transistors.

**14.** A Schmitt trigger according to claim 13 in conjunction with any one of claims 8 to 12,
characterized in

- that the transistors (M1, M2) of the differential amplifier of the first comparator (11) and the current source transistor (M5) constituting the first current source as well as the transistors (M9, M10) of the current mirror circuit of the second comparator (13) are constituted by N-channel MOS transistors, and the transistors (M7, M8) of the differential amplifier of the second comparator (13) and the current source transistor (M11) constituting the second current source as well as the transistors (M3; M4) of the current mirror circuit of the first comparator (11) are constituted by P-channel MOS transistors,
- that the current mirror circuit (M3, M4) of the first comparator (11) and the second current source transistor (M11) are connected to the positive pole (VDD) of the voltage supply source, and the current mirror circuit (M9, M10) of the second comparator (13) and the first current source transistor (M5) are connected to the negative pole (GND) of the voltage supply source,
- that the RS flipflop (15) comprises in known manner a Q output terminal and a $\overline{Q}$ output terminal,
- that the control terminals of the transistors (M5, M11) constituting the controllable switching means are commonly connected to the $\overline{Q}$ output terminal of the RS flipflop (15), and
- that an inverter (29) is connected between the output (23) of the second comparator (13) and the resetting input (R) of the RS flipflop (15).

**15.** A Schmitt trigger according to any one of claims 5 to 14,
characterized in that the second differential inputs of the differential amplifiers of the two comparators (11, 13) are connected to reference voltage sources (Vref1, Vref2) having different reference voltage values.

**16.** A Schmitt trigger according to any one of claims 5 to 14,
characterized in that the second differential inputs of the differential amplifiers of the two comparators (11, 13) are connected to the same reference voltage source (Vref) and that the different switching thresholds of the two comparators are constituted by offset voltages within the comparators.

**17.** A Schmitt trigger according to claim 16,
characterized in that the offset voltages within the comparators are obtained by different designs of the differential amplifier transistors (M1, M2; M7, M8), in case of MOS transistors in particular with respect to the channel widths thereof.

### Revendications

**1.** Trigger de Schmitt comportant un circuit comparateur qui associe, en fonction d'un seuil, un niveau bas ou haut à un signal d'entrée fourni à une entrée de signal (IN), comprenant :

a) deux comparateurs (11, 13) reliés en parallèle par rapport à l'entrée de signal (IN), un premier (11) des deux comparateurs étant affecté d'un seuil élevé (Vref1) et le deuxième (13) des deux comparateurs étant affecté d'un seuil inférieur (Vref2) ;
b) deux sources de courant (M5, M11) dont une première (M5) alimente le premier comparateur (11) et dont la deuxième (M11) alimente le deuxième comparateur (13) ;
c) un point mémoire (15) dont le contenu dépend de la valeur du signal d'entrée par rapport aux deux seuils (Vref1, Vref2) ; et
d) un circuit d'extinction qui coupe l'alimentation du premier comparateur (11) lorsque le signal d'entrée dépasse le premier seuil (Vref1), et qui coupe l'alimentation du deuxième comparateur (13) lorsque le signal d'entrée devient inférieur au deuxième seuil (Vref2) ;

caractérisé en ce que

e) le premier comparateur (11) passe à un état alimenté au-dessus du premier seuil (Vref1) et passe à un état non-alimenté en dessous du premier seuil ;
f) le deuxième comparateur (13) passe à un état alimenté en dessous du deuxième seuil (Vref2) et passe à un état non-alimenté au-dessus du deuxième seuil (Vref2) ;
g) le point mémoire (15) passe à un premier état lors du passage du premier comparateur (11) à l'état alimenté et passe à un deuxième état lors du passage du deuxième comparateur (13) à l'état alimenté ;

h) le circuit d'extinction rend conductrice la deuxième source de courant (M11) et bloque la première source de courant (M5) lorsque le point mémoire (15) passe au premier état, d'où il résulte que le premier comparateur (11) est bloqué immédiatement après son passage à l'état alimenté par le blocage de la première source de courant (M5) ; et

i) le circuit d'extinction rend conductrice la première source de courant (M5) et bloque la deuxième source de courant (M11) lorsque le point mémoire (15) passe au deuxième état, d'où il résulte que le deuxième comparateur (13) est bloqué immédiatement après son passage à l'état alimenté par le blocage de la deuxième source de courant (M11).

2. Trigger de Schmitt selon la revendication 1, caractérisé en ce que le point mémoire est constitué d'une bascule bistable (15) qui est basculée à un premier état lors du passage du premier comparateur (11) à l'état alimenté, et qui est basculée à un deuxième état lors du passage du deuxième comparateur (13) à l'état alimenté.

3. Trigger de Schmitt selon la revendication 2, caractérisé en ce que la bascule bistable comporte une bascule RS (15) dont l'entrée de mise à un (S) est reliée à la sortie (21) du premier comparateur (11) et dont l'entrée de mise à zéro (R) est reliée à la sortie (23) du deuxième comparateur (13).

4. Trigger de Schmitt selon l'une des revendications 1 à 3, caractérisé en ce que

- le circuit d'extinction comporte un premier dispositif commandé de commutation associé à la première source de courant (M5) pour bloquer la première source de courant (M5) et un deuxième dispositif commandé de commutation associé à la deuxième source de courant (M11) pour bloquer la deuxième source de courant (M11), et
- les deux dispositifs de commutation sont commandés par l'état de la bascule bistable (15), de manière que, dans le premier état, le premier dispositif de commutation bloque la première source de courant (M5) et rend conductrice la deuxième source de courant (M11) et que, dans le deuxième état, le deuxième dispositif de commutation bloque la deuxième source de courant (M11) et rend conductrice la première source de courant (M5).

5. Trigger de Schmitt selon l'une des revendications 1 à 4, caractérisé en ce que chacun des deux comparateurs (11, 13) comprend :

- un amplificateur différentiel (M1, M2 ; M7, M8) comportant deux entrées différentielles, deux sorties différentielles et une entrée de courant, et
- un miroir de courant (M3, M4 ; M9, M10) comportant une branche de transistor (M4, M10) et une branche de diode (M3, M9),

    et dans lequel

- une première des deux entrées différentielles est reliée à l'entrée de signal (IN) et la deuxième est reliée à une source de tension de référence (Vref),
- l'une des deux sorties différentielles est reliée à la branche de diode (M3, M9) et l'autre est reliée à la branche de transistor (M4, M10) ainsi qu'à la première (S) ou à la deuxième (R) entrée du point mémoire (15),
- chacune des deux sources de courant (M5, M11) est connectée entre l'entrée de courant et une borne (VDD, GND) d'une source d'alimentation, et
- la branche de transistor (M4, M10) et la branche de diode (M3, M9) sont reliées, du côté non-relié à l'amplificateur différentiel, à l'autre borne (GND, VDD) de la source d'alimentation.

6. Trigger de Schmitt selon la revendication 5, caractérisé en ce que, dans chaque comparateur (11, 13), l'amplificateur différentiel comporte des transistors (M1, M2 ; M7, M8) d'un premier type de conduction et le miroir de courant comporte des transistors (M3, M4, M9, M10) du type de conduction opposé.

7. Trigger de Schmitt selon la revendication 6, caractérisé en ce que la source de courant de chacun des comparateurs (11, 13) comporte un transistor de source de courant (M5, M11) qui est du même type de conduction que les transistors (M1, M2 ; M7, M8) de l'amplificateur différentiel.

8. Trigger de Schmitt selon la revendication 7, caractérisé en ce que le transistor de source de courant (M5, M11) de chacun des comparateurs (11, 13) constitue également le dispositif commandé de commutation et en ce que sa borne de commande est pour cela reliée à la sortie de commande ($\bar{Q}$) du point mémoire (15).

9. Trigger de Schmitt selon les revendications 4 et 5 ou 4 et selon la revendication 6 ou 7, caractérisé en ce que le dispositif commandé de commutation est connecté en série avec le transistor de source de courant (M5, M11).

10. Trigger de Schmitt selon les revendications 4 et 5 et 6 ou 7, caractérisé en ce que le dispositif commandé de commutation est connecté en série avec le transistor-diode (M3, M9) du miroir de courant.

11. Trigger de Schmitt selon la revendication 9 ou 10, caractérisé en ce que le dispositif commandé de commutation est constitué d'un transistor de commutation (M5, M11).

12. Trigger de Schmitt selon l'une des revendications 3 à 11, caractérisé en ce que la bascule RS (15) est constituée de deux portes NON OU (25, 27) rebouclées l'une sur l'autre en croix.

13. Trigger de Schmitt selon l'une des revendications 5 à 12, caractérisé en ce que tous les transistors sont des transistors MOS.

14. Trigger de Schmitt selon la revendication 13 et l'une des revendications 8 à 12, caractérisé en ce que

- les transistors (M1, M2) de l'amplificateur différentiel du premier comparateur (11) et le transistor de source de courant constituant la première source de courant (M5) et les transistors (M9, M10) du miroir de courant du deuxième comparateur (13) sont des transistors MOS à canal N et les transistors (M7, M8) de l'amplificateur différentiel du deuxième comparateur (13) et le transistor de source de courant constituant la deuxième source de courant (M11) et les transistors (M3, M4) du miroir de courant du premier comparateur (11) sont des transistors MOS à canal P,
- le miroir de courant (M3, M4) du premier comparateur (11) et le deuxième transistor de source de courant (M11) sont reliés à la borne positive (VDD) de la source d'alimentation et le miroir de courant (M9, M10) du deuxième comparateur (13) et le premier transistor de source de courant (M5) sont reliés à la borne négative (GND) de la source d'alimentation,
- la bascule RS (15) comporte de manière connue une borne de sortie Q et une borne de sortie $\overline{Q}$,
- les bornes de commande des transistors (M5, M11) qui constituent les dispositifs commandés de commutation sont reliées à la borne de sortie $\overline{Q}$ de la bascule RS (15), et
- un inverseur (29) est connecté entre la sortie (23) du deuxième comparateur (13) et l'entrée de mise à zéro (R) de la bascule RS (15).

15. Trigger de Schmitt selon l'une des revendications 5 à 14, caractérisé en ce que les deuxièmes entrées différentielles des amplificateurs différentiels des deux comparateurs (11, 13) sont reliées à des sources de tension de référence (Vref1, Vref2) fournissant des tensions de référence différentes.

16. Trigger de Schmitt selon une des revendications 5 à 14, caractérisé en ce que les deuxièmes entrées différentielles des amplificateurs différentiels des deux comparateurs (11, 13) sont reliées à la même source de tension de référence (Vref) et en ce que les seuils de commutation différents des deux comparateurs sont obtenus par des tensions de décalage internes aux comparateurs.

17. Trigger de Schmitt selon la revendication 16, caractérisé en ce que les tensions de décalage internes aux comparateurs sont obtenues par des constitutions différentes des transistors des amplificateurs différentiels (M1, M2 ; M7, M8), notamment des largeurs de canal dans le cas de transistors MOS.

FiG.1

FiG.2

FIG. 3

FiG.4

FiG.5